(19) Europäisches Patentamt
European Patent Office
Office européen des brevets

(11) **EP 2 656 405 B1**

(12) **EUROPÄISCHE PATENTSCHRIFT**

(45) Veröffentlichungstag und Bekanntmachung des Hinweises auf die Patenterteilung:
**01.10.2014  Patentblatt 2014/40**

(51) Int Cl.:
***H01L 35/32*** *(2006.01)*

(21) Anmeldenummer: **12712976.5**

(22) Anmeldetag: **07.03.2012**

(86) Internationale Anmeldenummer:
**PCT/EP2012/053877**

(87) Internationale Veröffentlichungsnummer:
**WO 2012/130568 (04.10.2012 Gazette 2012/40)**

(54) **THERMOELEKTRISCHE ANORDNUNG**

THERMO-ELECTRIC ARRANGEMENT

ENSEMBLE THERMOÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **30.03.2011  DE 102011001653**

(43) Veröffentlichungstag der Anmeldung:
**30.10.2013  Patentblatt 2013/44**

(73) Patentinhaber: **O-Flexx Technologies Gmbh**
**47059 Duisburg (DE)**

(72) Erfinder:
 • **SPAN, Gerhard**
 **A-6112 Wattens (AT)**
 • **WAGNER, Martin**
 **A-8983 Bad Mitterndorf (AT)**

(74) Vertreter: **Kohlmann, Kai**
 **Donatusstraße 1**
 **52078 Aachen (DE)**

(56) Entgegenhaltungen:
EP-B1- 1 287 566    DE-A1-102007 050 741
US-A- 3 956 017    US-A- 4 500 741

 • **GERHARD SPAN ET AL: "Miniaturized TEG with thermal generation of free carriers", PHYSICA STATUS SOLIDI (RRL) - RAPID RESEARCH LETTERS, Bd. 1, Nr. 6, 1. November 2007 (2007-11-01), Seiten 241-243, XP55035376, ISSN: 1862-6254, DOI: 10.1002/pssr.200701171**
 • **WAGNER M ET AL: "Design Optimization of Large Area Si/SiGe Thermoelectric Generators", SIMULATION OF SEMICONDUCTOR PROCESSES AND DEVICES, 2006 INTERNATIONAL CONFERENCE ON, IEEE, PI, 1. September 2006 (2006-09-01), Seiten 397-400, XP031008881, ISBN: 978-1-4244-0404-9**

**Beschreibung**

Die Erfindung betrifft eine Anordnung umfassend einen thermoelektrischen Generator mit einer von einer Wärmequelle Wärme aufnehmenden heißen Seite, einer an eine Wärmesenke Wärme abgebenden kalten Seite und elektrischen Anschlüssen zur Abgabe von elektrischer Energie mit einer Ausgangsspannung sowie eine elektrische Schaltung mit einer höchstzulässigen Eingangsspannung, deren Eingänge mit den elektrischen Anschlüssen des thermoelektrischen Generators verbunden sind. Außerdem betrifft die Erfindung ein Verfahren zum Betrieb einer derartigen Anordnung.

Ein thermoelektrischer Generator, auch kurz als TEG bezeichnet, ist eine Einrichtung, die unter Nutzung des thermoelektrischen Effekts Wärmeenergie in elektrische Energie umwandelt.

Der thermoelektrische Effekt, auch als Seebeck-Effekt bezeichnet, beschreibt die umkehrbare Wechselwirkung zwischen Temperatur und Elektrizität. Die Seebeck-Spannung wird bestimmt durch:

$$U_{Seebeck} = \alpha \times \delta T$$

mit

$\delta T$ Temperaturdifferenz zwischen heißer und kalter Seite
$\alpha$ - Seebeck - Koeffizient bzw. Thermokraft

Der Seebeck-Koeffizient hat die Dimension einer elektrischen Spannung pro Temperaturdifferenz (V/K). Die Größe des Seebeck-Koeffizienten ist maßgeblich für die Höhe der Seebeck-Spannung verantwortlich.

Ein thermoelektrischer Generator besteht aus unterschiedlich dotierten Halbleitermaterialien. Gebräuchliche Halbleitermaterialien für thermoelektrische Generatoren sind Halbleitermaterialien, wie insbesondere $Bi_2Te_3$, $Bi_2Se_3$, $Sb_2Te_3$, PbTe, SiGe oder $FeSi_2$ und deren Legierungen.

Ein herkömmlicher thermoelektrischer Generator ist aus zwei oder mehreren kleinen Quadern je aus p- und n-dotiertem Halbleitermaterial, die abwechselnd oben und unten durch Metallbrücken miteinander verbunden sind, aufgebaut. Die Metallbrücken bilden zugleich die thermischen Kontaktfläche und sind zumeist durch eine Keramikplatte isoliert. Die unterschiedlichen Quader aus p- und n-dotiertem Halbleitermaterial sind elektrisch in Reihe geschaltet. Die Keramikplatten weisen einen Abstand von etwa 3 mm bis 5 mm auf, zwischen denen die Quader angeordnet, insbesondere eingelötet sind. Eine der Keramikplatten bildet die heiße, die gegenüberliegende Keramikplatte die kalte Seite des thermoelektrischen Generators. Die heiße Seite nimmt von einer Wärmequelle Wärme auf, während die kalte Seite an eine Wärmesenke Wärme abgibt. Durch Herstellen der Temperaturdifferenz $\delta_T$ zwischen heißer und kalter Seite wird die Seebeck-Spannung $U_{seebeck}$ an den Anschlüssen des thermoelektrischen Generators erzeugt,

Um den Wirkungsgrad eines thermoelektrischen Generators zu steigern, wird in der EP 1 287 566 B1 ein thermoelektrisches Element und ein Modul mit mehreren elektrisch in Reihe geschalteten thermoelektrischen Elementen offenbart.

Das thermoelektrische Element weist mindestens eine n-Schicht und mindestens eine p-Schicht eines oder mehrerer dotierter Halbleiter auf, wobei die n-Schicht (en) und die p-Schicht (en) unter Ausbildung wenigstens eines pn-Übergangs angeordnet sind. Zumindest eine n-Schicht und zumindest eine p-Schicht sind elektrisch selektiv kontaktiert und ein Temperaturgradient wird parallel (x-Richtung) zur Grenzschicht zwischen wenigstens einer n-und p-Schicht angelegt. Mindestens ein pn-Übergang ist im wesentlichen entlang der gesamten, vorzugsweise längsten Ausdehnung der n-Schicht (en) und der p-Schicht (en) und damit im wesentlichen entlang deren gesamter Grenzschicht ausgebildet.

Durch den Temperaturgradienten entlang der großflächigen pn-Grenzfläche entsteht ein Temperaturunterschied entlang dieses länglich ausgebildeten pn-Übergangs zwischen zwei Enden eines pn-Schichtpakets, der dazu führt, dass der Wirkungsgrad des thermoelektrischen Elementes höher ist als bei herkömmlichen thermoelektrischen Generatoren, die keinen Temperaturgradienten entlang und innerhalb des pn-Übergangsaufweisen. Die thermoelektrischen Elemente sind bei dem Modul zwischen zwei Platten thermisch parallel angeordnet. Die Platten dienen der verbesserten thermischen Ankopplung sowohl auf der kalten als auch heißen Seite. Sie sind vorzugsweise als gute Wärmeleiter ausgebildet, die insbesondere aus keramischen, elektrisch nicht leitenden Werkstoffen bestehen. Die Offenbarung der EP 1 287 566 B1, insbesondere zum Aufbau der thermoelektrischen Elemente (Figur 3) und des Moduls (Figur 13) sowie zu den verwendeten Halbleitermaterialien, wird ausdrücklich in die vorliegende Anmeldung einbezogen.

Eine gattungsgemäße Anordnung wird in der DE 10 2008 023 806 Al offenbart. Die Anordnung ist in das Abgassystem eines Kraftfahrzeugs eingebunden, in dem die so genannte heiße Seite des TEG mit einer abgasführenden Leitung des Abgasstrangs wärmeleitend verbunden wird, während die kalte Seite des TEG beispielsweise mit einer eine Kühlflüssigkeit führenden Kühlmittelleitung des Motorkühlsystems des Kraftfahrzeugs thermisch gekoppelt ist. Elektrisch ist der TEG über eine Gleichspannungskoppeleinrichtung in Form eines Gleichspannungswandlers in das Bordnetz des Kraftfahrzeugs eingekoppelt. Die Anordnung aus TEG und Gleichspannungswandler verbessert den energetischen Wirkungsgrad des Kraftfahrzeugs erheblich. Die Einbindung der Anordnung in das Abgassystem des Kraftfahrzeugs setzt jedoch eine Neukonstruktion des Abgassystems voraus. Das Abgassystem umfasst einen Abgaskanal, der zwei parallel verlaufende Teil-Abgaskanäle aufweist, wobei die Teil-Abgaskanäle stromabwärts wieder zusammengeführt sind. Einer der beiden Teil-Abgaskanäle ist mit dem thermoelektrische Generator thermisch gekoppelt, wobei im Abgaskanal zumindest ein Schaltelement zur Lenkung des Abgasstroms vorhanden ist derart, dass in Abhängigkeit von der Schaltstellung des Schaltelementes der Abgasstrom ausschließlich durch den ersten Teil-Abgaskanal, ausschließlich durch den zweiten Teil-Abgaskanal oder anteilig durch beide Teil-Abgaskanäle strömt. Ferner ist eine Steuereinrichtung zur Ansteuerung des mindestens einen Schaltelementes vorgesehen. Die Ausgangsspannung des in dem Teil-Abgaskanal angeordneten thermoelektrischen Generators ist nahezu proportional zur Temperaturdifferenz zwischen heißer und kalter Seite des thermoelektrischen Generators. Um Beschädigungen des mit dem thermoelektrischen Generator verbundenen Gleichspannungswandlers und dem Bordnetz des Kraftfahrzeugs durch eine zu hohe Ausgangsspannung des thermoelektrischen Generators in bestimmten Betriebssituationen zu vermeiden, ist es erforderlich zu heiße Abgase an dem thermoelektrischen Generator vorbei zu führen. Durch diese Bypass-Lösung ist es möglich, den thermoelektrischen Generator für mittlere Motorleistungen und somit Abgastemperaturen und -massenströme auszulegen, die den Großteil des Fahrzyklus ausmachen. Des Weiteren kann der Gleichspannungswandler auf den am häufigsten genutzten mittleren Leistungsbereich ausgelegt werden. Ein wesentlicher Nachteil des Standes der Technik besteht jedoch darin, dass das Abgassystem zwei parallel verlaufende Teil-Abgaskanäle aufweisen muss und zudem gesteuerte Schaltelemente in den Abgasstrang eingebaut werden müssen.

Ausgehend von diesem Stand der Technik liegt der Erfindung die Aufgabe zu Grunde, eine Anordnung der eingangs erwähnten Art zu schaffen, die sich weitgehend unabhängig von der Größe der Temperaturdifferenz zwischen heißer und kalter Seite des thermoelektrischen Generators mit einer Wärmequelle, insbesondere einem Abgassystem einer Brennkraftmaschine, verbinden lässt, wobei Beschädigungen der mit dem thermoelektrischen Generator verbundenen elektrischen Schaltung aufgrund eines Überschreitens von deren höchstzulässiger Eingangsspannung ohne Veränderungen an der Wärmequelle, insbesondere dem Abgassystem, vermieden werden sollen.

Diese Aufgabe wird bei einer Anordnung der eingangs erwähnten Art dadurch gelöst, dass der thermoelektrische Generator mindestens ein thermoelektrisches Element umfasst, das jeweils aus mindestens einer n-Schicht und mindestens einer p-Schicht aus thermoelektrischem Material unter Ausbildung wenigstens eines sich entlang einer Grenzschicht ausbildenden pn-Übergangs besteht, wobei ein Temperaturgradient parallel zur Grenzschicht zwischen der heißen und der kalten Seite des thermoelektrischen Generators anlegbar ist und dass die n-und p-Schicht (des thermoelektrischen Generators eine Dicke aufweisen, bei der eine Sättigung der Ausgangsspannung unterhalb oder bei Erreichen der höchstzulässigen Eingangsspannung der elektrischen Schaltung eintritt.

Der thermoelektrische Generator umfasst mindestens ein an sich aus der EP 1 287 566 B1 bekanntes thermoelektrisches Element. Das Überschreiten der höchstzulässigen Eingangsspannung der elektrischen Schaltung wird dadurch verhindert, dass sich die Ausgangsspannung des thermoelektrischen Generators ab einer bestimmten Temperaturdifferenz zwischen heißer und kalter Seite nicht mehr nennenswert erhöht. Diese Sättigung der Ausgangsspannung erfolgt vorzugsweise bei Erreichen der höchst zulässigen Eingangsspannung oder geringfügig unterhalb. Beschädigungen der elektrischen Schaltung und nachfolgender Komponenten werden ohne aufwendige Eingriffe in die Wärmequelle bzw. Wärmesenke wirksam vermieden. Insbesondere bei Einbindung der erfindungsgemäßen Anordnung in das Abgassystem eines Kraftfahrzeuges ist kein Teil-Abgaskanal als Bypass für zu heiße Abgase mehr erforderlich. Des Weiteren entfallen die Schaltelemente sowie die Steuereinrichtung zur Ansteuerung der Schaltelemente.

Bei dem thermoelektrischen Generator, der mindestens ein an sich aus der EP 1 287 566 B1 bekanntes thermoelektrisches Element umfasst, hängt der Eintritt der Sättigung der Ausgangsspannung davon ab, wie die Transportfähigkeit der thermoelektrischen Schichten und die Generationseffizienz des pn-Übergangs, an dem ein Temperaturgradient angelegt ist, aufeinander abgestimmt sind. Bei konstanten Parametern, wie insbesondere Länge und Breite des thermoelektrischen Generators, Dotierung und Defektdichte, wird das Sättigungsverhalten des thermoelektrischen Generators über die Dicke der n- und p-Schichten eingestellt. Mit dicker werdenden Schichten erhöht sich der Wert, bei dem die Sättigung der Ausgangsspannung eintritt. Durch Verändern der Schichtdicke lässt sich folglich der thermoelektrische Generator an die höchstzulässige Eingangsspannung der elektrischen Schaltung anpassen.

In einer Veröffentlichung zu dem thermoelektrischen Generator nach der EP 1 287 566 B1 "Gerhard Span et al: "Miniaturized TEG with thermal generation of free carriers", Physica Status Soldi (PRL) - Rapid Research letters, Bd. 1, Nr.6, 1. November 2007, Seiten 241 -243" wird ergänzend offenbart, dass die Kontakte des thermoelektrischen Elementes nach der EP 1 287 566 B1 an der kalten Seite mit einem Lastwiderstand verbindbar sind, in dem ein äußerer Strom fließt. Den Abbildungen der Veröffentlichung lässt sich weiter entnehmen, wie sich die unterschiedlichen thermischen Widerstände thermoelektrischer Generatoren auf die Effizienz auswirken. In einer der Abbildungen ist erkennbar, dass mit abnehmender Länge und zunehmender Dicke der thermoelektrisch wirksamen Schicht, das thermoelektrische Material zwischen heißer und kalter Seite besser leitfähig wird, wodurch die nutzbare Temperaturdifferenz und damit die Effizienz kleiner werden.

In einer vorteilhaften Ausgestaltung der Erfindung umfasst die Anordnung eine Wärmequelle, die thermisch an die heiße Seite des thermoelektrischen Generators gekoppelt ist. Die thermische Kopplung kann beispielsweise mit Hilfe eines Wärmetauschers erfolgen. Als Wärmequelle dient insbesondere ein Bestandteil eines Abgassystems einer Brennkraftmaschine, wobei aufgrund der erfindungsgemäßen Anordnung keine konstruktive Anpassung des Abgassystems erforderlich ist.

Nachfolgend wird die Erfindung anhand der Abbildungen näher erläutert. Es zeigen:

Abbildung 1  eine schematische Darstellung einer erfindungsgemäßen Anordnung,

Abbildung 2  eine Darstellung der Ausgangsspannung von unterschiedlich ausgelegten thermoelektrischen Generatoren nach Abbildung 1 in Abhängigkeit von der Temperaturdifferenz,

Abbildung 3  eine Darstellung der Leistungsdichte von unterschiedlich ausgelegten thermoelektrischen Generatoren in Abhängigkeit von der anliegenden Temperaturdifferenz,

Abbildung 4  Darstellung des Seebeck-Koeffizienten für n-dotiertes Silizium verschiedner Dopandenkonzentration und

Abbildung 5  Darstellung des Seebeck-Koeffizienten für p-dotiertes Silizium verschiedener Dopandenkonzentration.

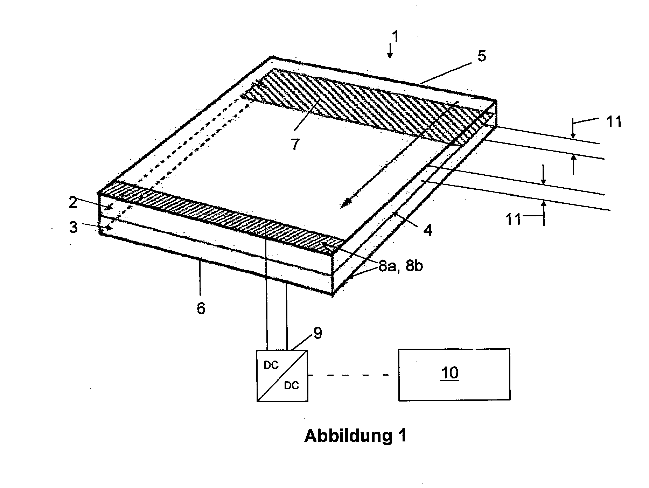

Abbildung 1 zeigt eine erfindungsgemäße Anordnung mit einem an sich aus der EP 1 287 566 B1 bekannten thermoelektrischen Generator (1), der im dargestellten Ausführungsbeispiel vereinfacht lediglich ein thermoelektrisches Element umfasst, das aus einer p-Schicht (2) aus thermoelektrischem Material und einer n-Schicht (3) aus thermoelektrischem Material unter Ausbildung eines sich entlang der Grenzschicht ausbildenden -pn-Übergangs (4) besteht. An der oberen Stirnseite des Schichtpaketes weist der thermoelektrische Generator (1) eine heiße Seite (5) und an der gegenüberliegenden Stirnseite eine kalte Seite (6) auf. Entlang der Grenzschicht zwischen der heißen und kalten Seite (5, 6) ist ein Temperaturgradient anlegbar, in dem die heiße Seite von einer nicht dargestellten Wärmequelle, beispielsweise einem Abgassystem einer Brennkraftmaschine, Wärme aufnimmt und die kalte Seite an eine Wärmesenke, beispielsweise eine Kühlflüssigkeitsleitung der Brennkraftmaschine oder aber auch die umgebungsluft Wärme abgibt. Bei anliegender Temperaturdifferenz zwischen heißer und kalter Seite (5, 6) werden Ladungsträger (Elektronen und Löcher) an der heißen Seite (5) des pn-Übergangs (4) in einer Generationszone (7) thermisch generiert. Die Ladungsträger werden durch das Built-In-Potential des pn-Übergangs (4) getrennt und durch den Seebeck-Effekt in der n- und p-Schicht von der heißen Seite (5) zur kalten Seite (6) transportiert. An der kalten Seite (6) werden die Ladungsträger durch elektrische Anschlüsse (8a, 8b) in Form von Kontakten abgeführt. Die elektrischen Anschlüsse (8a, 8b) des thermoelektrischen Generators (1) sind mit einer elektrischen Schaltung (9), nämlich einem Gleichspannungswandler, verbunden. Der Gleichspannungswandler dient dem Zweck, die von dem thermoelektrischen Generator (1) erzeugte elektrische Energie in ein schematisch dargestelltes Bordnetz (10) eines Kraftfahrzeuges einzukoppeln.

Der thermoelektrische Generator (1) weist bei steigenden Temperaturdifferenzen zwei Betriebsbereiche auf - den generationslimitierten Bereich und den transportlimitierten Bereich. Im generationslimitierten Bereich wird ein Großteil der an der heißen Seite (5) generierten Ladungsträger zu den elektrischen Anschlüssen (8a, 8b) abgeführt. Die Anzahl generierter Ladungsträger steigt mit der Temperatur exponentiell an, wobei sich aufgrund der thermischen Leitfähigkeit des thermoelektrischen Generators (1) ein entsprechender Temperaturgradient entlang des pn-Übergangs (4) einstellt. Werden bei höheren Temperaturen im transportlimitierten Bereich für eine gewisse Dicke der n-und p-Schicht (2, 3) ein Überhang an Ladungsträgern generiert, stellt sich entlang der n- und p-Schicht ein neues Gleichgewicht ein, und Ladungsträger rekombinieren wieder auf ihrem Weg zu den elektrischen Anschlüssen (8a, 8b). Daraus resultierend ergibt sich eine mit steigender Temperaturdifferenz zunächst schwächer steigende und dann saturierende Ausgangsspannung.

Der Übergang vom generationslimitierten Bereich in den transportlimitierten Bereich und somit die Temperaturdifferenz, bei der eine Sättigung der Ausgangsspannung eintritt, hängt somit von der Transportfähigkeit der n- und p-Schichten (2, 3) und der Generationseffizienz des pn-Übergangs (4) ab. Bei gegebenen Parametern, wie Länge des thermoelektrischen Generators, Dotierung und Defektdichte, lässt sich daher das Transportverhalten der n- und p-Schicht (2, 3) am einfachsten durch Veränderung der Dicke (11) der n- und p-Schicht (2, 3) einstellen. Typische Dicken der p- und n-Schichten liegen im Bereich zwischen 10 und 100 $\mu$m, während die typische Länge des thermoelektrischen Generators im Millimeterbereich liegt.

Die vorstehenden Erläuterungen veranschaulichen, dass durch Bestimmung der Dicke der n- und p-Schicht (2, 3) die Höhe der maximalen Ausgangsspannung des thermoelektrischen Generators (1) einstellbar ist. In Folge dessen lässt sich die maximale Ausgangsspannung des thermoelektrischen Generators (1) innerhalb der erfindungsgemäßen Anordnung an die höchstzulässige Eingangsspannung der elektrischen Schaltung (9) anlassen.

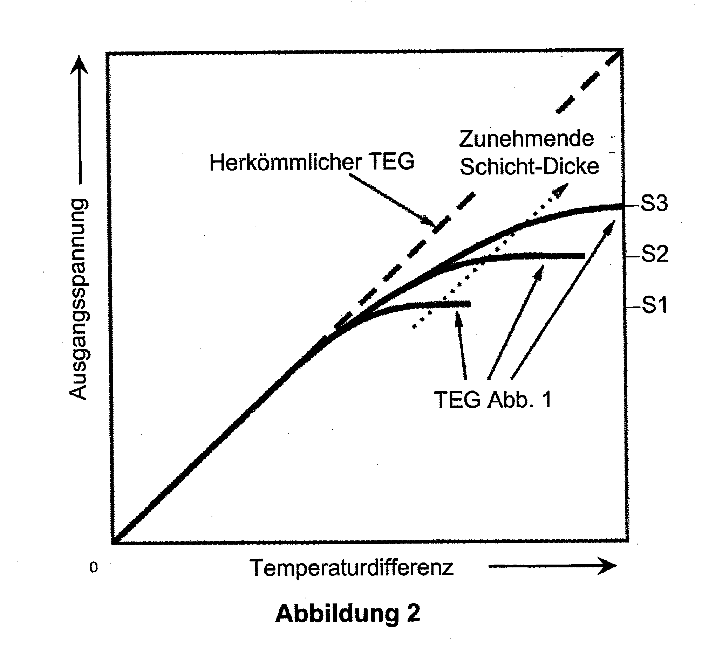

Abbildung 2 veranschaulicht den Zusammenhang zwischen der Schichtdicke der n- und p-Schichten (2,3) und der Sättigung der Ausgangsspannung. Die in Abbildung 2 dargestellte gestrichelte Linie zeigt das Verhalten eines herkömmlichen thermoelektrischen Generators, bei dem die Ausgangsspannung proportional mit der Temperaturdifferenz zwischen heißer und kalter Seite des thermoelektrischen Generators steigt. Die durchgezogenen Linien beziehen sich indes auf das Verhalten der Ausgangsspannung eines thermoelektrischen Generators (1), bei dem über die Dicke (11) der n- und p-Schichten (2, 3) eine Sättigung der Ausgangsspannung bei unterschiedlichen Werten der Ausgangsspannung auftritt. Die Sättigung der Ausgangsspannung steigt mit dicker werdenden p- und n-Schichten (2, 3). Für die im vergleich geringste Dicke (11) der p- und n-Schicht (2, 3) tritt eine Sättigung bei einer Ausgangsspannung (S1), für die mittlere Dicke (11) bei einer Ausgangsspannung (S2) und für die größte Dicke (11) bei einer Ausgangsspannung (S3) ein. Da die n- und p-Schichten (2, 3) mit größerer Dicke eine höhere Transportfähigkeit für die Ladungsträger aufweisen, verschiebt sich auch die Temperaturdifferenz, bei der die Sättigung der Ausgangsspannungen (S1 - S3) jeweils eintritt nach oben.

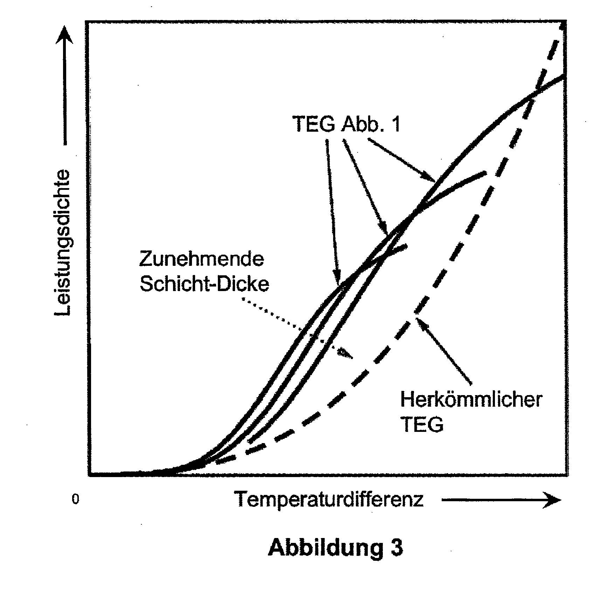

Abbildung 3 zeigt, dass bei vergleichsweise niedrigen Temperaturdifferenzen dünnere n- und p-Schichten (2, 3) sich als vorteilhaft herausstellen, da aufgrund der geringeren Temperaturdifferenz weniger Ladungsträger in der Generationszone (7) generiert werden und von der n- und p-Schicht (2, 3) effektiv zu den Anschlüssen (8a, 8b) transportiert werden können. Mit steigenden Temperaturdifferenzen ergibt sich für die dickeren n- und p-Schichten (2, 3) eine höhere Leistungsdichte. Aus Abbildung 3 ist weiter erkennbar, dass die Ausgangsleistung eines herkömmlichen thermoelektrischen Generators nahezu quadratisch mit der Temperaturdifferenz ansteigt, während die Ausgangsleistung des thermoelektrischen Generators (1) zunächst exponentiell, das heißt mehr als quadratisch mit der Temperaturdifferenz ansteigt und bei höheren Temperaturdifferenzwerten durch die Sättigung der Ausgangsspannung begrenzt ist. Durch dieses Verhalten des thermoelektrischen Generators (1) kann die Ausgangsleistung gegenüber einem herkömmlich aufgebauten thermoelektrischen Generator für eine bestimmte Temperaturdifferenz optimiert werden. Die Anordnung lässt sich daher besonders effizient an ein Abgassystem einer Brennkraftmaschine anpassen, die im mittleren Leistungsbereich betrieben wird.

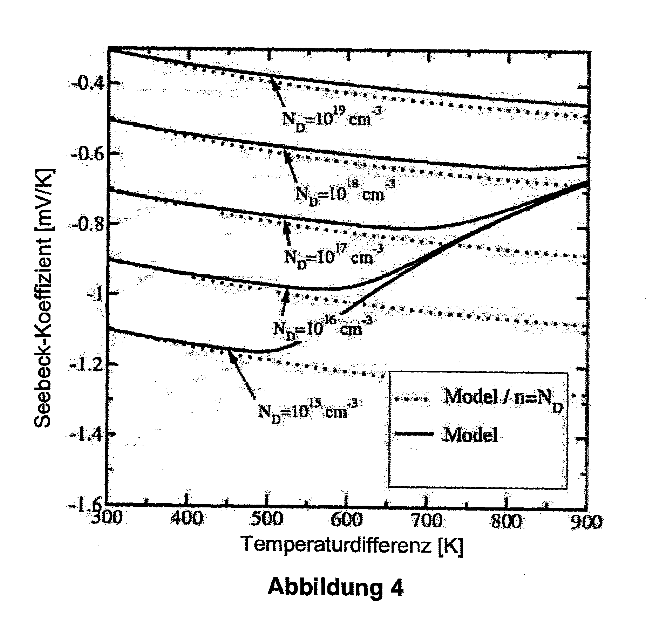

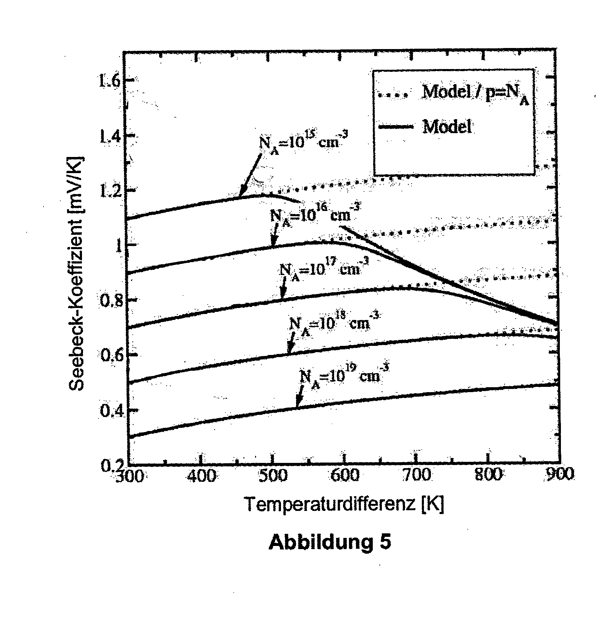

Freie Ladungsträger und somit die Leitfähigkeit, aber auch der Seebeck-Koeffizient in einem Halbleiter werden durch die Dotierung des Materials eingestellt. Man unterscheidet zwischen so genannten intrinsischen und extrinsischen Halbleitern, wobei jeder Halbleiter mit steigender Temperatur in den intrinsischen Bereich gerät. Während in einem extrinsischen Halbleiter nur eine Ladungsträgerart (also entweder Elektronen oder Löcher, je nach Art der Dotierung) zum elektrischen Transport beiträgt, existieren im intrinsischen Halbleiter beide Ladungsträgertypen durch thermische Generation. Da die thermische Drift auf beide Ladungsträgertypen in die gleiche Richtung wirkt (von warm nach kalt), die Ladungsträger allerdings Ladungen mit unterschiedlichen Vorzeichen tragen und auch Seebeck-Koeffizienten mit unterschiedlichem Vorzeichen aufweisen, sinkt der Seebeck-Koeffizient eines dotierten Halbleiters am überging vom extrinsischen zum intrinsischen Bereich durch die vorzeichenfalschen Beiträge der zusätzlich aufkommenden jeweils anderen Ladungsträger (Elektronen im p-Halbleiterbereich, Löcher im n-Halbleiterbereich) massiv ab (Abbildungen 4, 5). In den Abbildungen sind Werte für verschieden dotierte Siliziumproben zu sehen, das grundlegende Verhalten ist für andere Halbleitermaterialien analog.

Aufgrund des vorstehenden Verhaltens kann auch durch die Dotierung des n- und p-Halbleitermaterials die Sättigung der Ausgangsspannung eingestellt werden.

**Bezugszeichenliste**

| Nr. | Bezeichnung |
|---|---|
| 1 | thermoelektrischer Generator |
| 2 | p-Schicht |
| 3 | n-schicht |
| 4 | pn-Übergang |
| 5 | heiße Seite |
| 6 | kalte Seite |
| 7 | Generationszone |
| 8 a, b | elektrische Anschlüsse |
| 9 | elektrische Schaltung |
| 10 | Bordnetz |
| 11 | Dicke |

**Patentansprüche**

1. Anordnung umfassend einen thermoelektrischen Generator mit einer von einer Wärmequelle Wärme aufnehmenden heißen Seite, einer an eine Wärmesenke Wärme abgebenden kalten Seite und elektrischen Anschlüssen zur Abgabe von elektrischer Energie mit einer Ausgangsspannung sowie eine elektrische Schaltung mit einer höchstzulässigen Eingangsspannung, deren Eingange mit den elektrischen Anschlüssen des thermoelektrischen Generators verbunden sind, **dadurch gekennzeichnet, dass**

   - der thermoelektrische Generator (1) mindestens ein thermoelektrisches Element umfasst, das jeweils aus mindestens einer n-Schicht (2) und mindestens einer p-Schicht (3) aus thermoelektrischem Material unter Ausbildung wenigstens eines sich entlang einer Grenzschicht ausbildenden pn-Übergangs (4) besteht, wobei ein Temperaturgradient parallel zur Grenzschicht zwischen der heißen und der kalten Seite (5, 6) des thermoelektrischen Generators (1) anlegbar ist und
- dass die n- und p-Schicht (2, 3) des thermoelektrischen Generators (1) eine Dicke (11) aufweisen, bei der <u>eine Sättigung der</u> Ausgangsspannung (S1, S2, S3) unterhalb oder bei Erreichen der höchstzulässigen Eingangsspannung der elektrischen Schaltung (9) eintritt.

2. Anordnung nach Anspruch 1, **dadurch gekennzeichnet, dass** die Anordnung eine Wärmequelle umfasst, die thermisch an die heiße Seite (5) des thermcelektrischen Generators (1) gekoppelt ist.

3. Anordnung nach Anspruch 2, **dadurch gekennzeichnet, dass** die Wärmequelle ein Bestandteil eines Abgassystems einer Brennkraftmaschine ist.

4. Anordnung nach einem der Ansprüche 1 bis 3, **dadurch gekennzeichnet, dass** die elektrische Schaltung (9) ein Gleichspannungswandler ist.

5. Verfahren zum Betrieb einer Anordnung umfassend einen thermoelektrischen Generator (1) mit einer von einer Wärmequelle Wärme aufnehmenden heißen Seite (5), einer an eine Wärmesenke Wärme abgebenden kalten Seite (6) und elektrischen Anschlüssen (8a, 8b) zur Abgabe von elektrischer Energie mit einer Ausgangsspannung (S1, S2, S3) sowie eine elektrische Schaltung (9) mit einer höchstzulässigen Eingangsspannung, deren Eingänge mit den elektrischen Anschlüssen (8a, 8b) des thermoelektrischen Generators (1) verbunden sind, **dadurch gekennzeichnet, dass**

    - eine Temperaturdifferenz zwischen heißer und kalter Seite (2, 3) des thermoelektrischen Generators (1) ausgebildet wird, in dem von der heißen Seite (5) von der Wärmequelle Wärme aufgenommen und von der kalten Seite (6) an die Wärmesenke Wärme abgegeben wird,
    - wobei sich die Ausgangsspannung (S1, S2, S3) des thermoelektrischen Generators (1) in einem ersten Wertebereich für die Temperaturdifferenz zwischen heißer und kalter Seite (2, 3) mit steigenden Werten bis zu einer maximalen Ausgangsspannung erhöht, die geringer oder gleich der höchstzulässigen Eingangsspannung der elektrischen Schaltung (9) ist,
    - wobei sich die Ausgangsspannung (S1, S2, S3) des thermoelektrischen Generators (1) in einem zweiten Wertebereich für die Temperaturdifferenz zwischen heißer und kalter Seite (2, 3) mit steigenden Werten nicht weiter erhöht und

- wobei die Temperaturdifferenzen des zweiten Wertebereichs höher als die Temperaturdifferenzen im ersten Wertebereich sind.

**Claims**

1. An arrangement comprising a thermo-electric generator having a hot side which absorbs heat from a heat source, and a cold side which discharges heat to a heat sink and electrical terminals for outputting electrical energy having an output voltage and an electric circuit having a maximum permissible input voltage, the inputs of which are connected to the electrical terminals of the thermo-electric generator, **characterized in that**

    - the thermo-generator (1) includes at least one thermo-electric element each consisting of at least one n-type layer (2) and at least one p-type layer (3) of thermo-electric material, forming at least one pn junction (4) along a boundary layer, wherein a temperature gradient can be applied parallel to the boundary layer between the hot side and the cold side (5, 6), and
    - the n-type and p-type layer (2, 3) of the thermo-electric generator (1) have a thickness (11) at which a saturation of the output voltage (S1, S2, S3) occurs below or on reaching the maximum permissible input voltage of the electric circuit (9).

2. The arrangement according to claim 1, **characterized in that** the arrangement comprises a heat source which is thermally coupled to the hot side (5) of the thermo-electric generator (1).

3. The arrangement according to claim 2, **characterized in that** the heat source is a component of an exhaust system of an internal combustion engine.

4. The arrangement according to any one of claims 1 to 3, **characterized in that** the electric circuit (9) is a direct voltage transformer.

5. A method for operating an arrangement comprising a thermo-electric generator (1) having a hot side (5) which absorbs heat from a heat source, a cold side (6) which discharges heat to a heat sink, and electrical terminals (8a, 8b) for outputting electric energy having an output voltage (S1, S2, S3), as well as an electric circuit (9) having a maximum permissible input voltage, the inputs of which are connected to the electrical terminals (8a, 8b) of the thermo-electric generator (1), **characterized in that**

    - a temperature difference between the hot and the cold side (2, 3) of the thermo-electric generator (1) is formed whereby heat from the heat source is absorbed by the hot side (5) and heat is discharged by the cold side (6) to the heat sink,
- wherein in a first value range for the temperature difference between the hot and cold side (2, 3), the output voltage (S1, S2, S3) of the thermoelectric generator (1) is increased with increasing values up to a maximum output voltage that is less than or equal to the maximum permissible input voltage of the electric circuit (9),
- wherein in a second value range for the temperature difference between the hot and cold side (2, 3), the output voltage (S1, S2, S3) of the thermoelectric generator (1) is not increased further with increasing values and
- wherein the temperature differences of the second value range are higher than the temperature differences in the first value range.

## Revendications

1. Agencement comportant un générateur thermoélectrique, avec un côté chaud prélevant de la chaleur à partir d'une source thermique, un côté froid restituant de la chaleur à un dissipateur thermique et des raccords électriques destinés à restituer de l'énergie électrique avec une tension de sortie, ainsi qu'un circuit électrique avec une tension d'entrée maximale admissible, dont les entrées sont reliées avec les raccords électriques du générateur thermoélectrique, **caractérisé en ce que**

    - le générateur thermoélectrique (1) comprend au moins un élément thermoélectrique qui est constitué chaque fois d'au moins une couche n (2) et d'au moins une couche p (3) en matière thermoélectrique en formant au moins un passage pn (4) se formant le long de sa couche limitrophe, un gradient thermique étant applicable à la parallèle de la couche limitrophe entre le côté (5, 6) chaud et froid du générateur thermoélectrique (1) et
    - **en ce que** la couche n (2) et la couche p (3) du générateur thermoélectrique (1) présentent une épaisseur (11) à laquelle une saturation de la tension de sortie (S1, S2, S3) intervient en-dessous ou à l'atteinte de la tension d'entrée maximale admissible du circuit électrique (9).

2. Agencement selon la revendication 1, **caractérisé en ce que** l'agencement comprend une source thermique, qui est couplée thermiquement sur le côté chaud (5) du générateur thermoélectrique (1).

3. Agencement selon la revendication 2, **caractérisé en ce que** la source thermique est un constituant d'un système des gaz d'échappement d'un moteur à combustion interne.

4. Agencement selon l'une quelconque des revendications 1 à 3, **caractérisé en ce que** le circuit électrique (9) est un convertisseur continu-continu.

5. Procédé d'exploitation d'un agencement comportant un générateur thermoélectrique (1), avec un côté chaud (5) prélevant de la chaleur à partir d'une source thermique, un côté froid (6) restituant de la chaleur à un dissipateur thermique et des raccords électriques (8a, 8b) destinés à restituer de l'énergie électrique avec une tension de sortie (S1, S2, S3), ainsi qu'un circuit électrique (9) avec une tension d'entrée maximale admissible, dont les entrées sont reliées avec les raccords électriques (8a, 8b) du générateur thermoélectrique (1), **caractérisé en ce**

    - **qu'**il est créé une température différentielle entre le côté chaud et froid (2, 3) du générateur thermoélectrique (1), en ce que le côté chaud (5) reprend de la chaleur à partir de la source thermique et le côté froid (6) la restitue au dissipateur thermique,
    - la tension de sortie (S1, S2, S3) du générateur thermoélectrique (1) augmentant dans une première fourchette de valeurs pour la température différentielle entre le côté chaud et froid (2, 3) avec des valeurs croissantes jusqu'à une tension de sortie maximale qui est inférieure ou égale à la tension d'entrée maximale admissible du circuit électrique (9),
    - la tension de sortie (S1, S2, S3) du générateur thermoélectrique (1) ne continuant pas d'augmenter dans une deuxième fourchette de valeurs pour la température différentielle entre le côté chaud et froid (2, 3) avec des valeurs croissantes et
    - la température différentielle de la deuxième fourchette de valeurs étant supérieure à la température différentielle dans la première fourchette de valeurs.

**Abbildung 1**

**Abbildung 2**

**Abbildung 3**

EP 2 656 405 B1

Abbildung 4

**Abbildung 5**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1287566 B1

- DE 102008023806 A1

**In der Beschreibung aufgeführte Nicht-Patentliteratur**

- **GERHARD SPAN et al.** Miniaturized TEG with thermal generation of free carriers. *Physica Status Soldi (PRL) - Rapid Research letters,* 01. November 2007, vol. 1 (6), 241-243